# EUROPEAN PATENT SPECIFICATION

(11) **EP 3 792 644 B1**
(45) Date of publication and mention of the grant of the patent: **12.06.2024**
(21) Application number: 19197137.3
(22) Date of filing: 12.09.2019
(51) Int. Cl.: G01R 31/12, G01R 31/62

(54) **NON-DESTRUCTIVE TESTING OF A DIELECTRIC STRENGTH OF A LIQUID**
NICHT ZERSTÖRENDE PRÜFUNG EINER DIELEKTRISCHEN STÄRKE EINER FLÜSSIGKEIT
ESSAI NON DESTRUCTIF DE LA RESISTANCE DIELECTRIQUE D'UNE LIQUIDE

(43) Date of publication of application: 17.03.2021
(73) Proprietor: Ostbayerische Technische Hochschule Regensburg, 93049 Regensburg (DE)
(72) Inventor: HAUSLER, Peter, 84094 Ratzenhofen (DE); FISCHER, Johannes, 93458 Eschlkamp (DE); HIRSCH, Thomas, 93047 Regensburg (DE); BIERL, Rudolf, 93053 Regensburg (DE)
(74) Representative: Koplin, Moritz

(56) References cited:
- EP-A2- 2 407 795
- CN-A- 106 443 386
- CN-A- 107 831 417
- CN-A- 108 120 906
- FR-A1- 2 251 009
- KR-A- 20050 050 515
- RU-U1- 172 345
- US-A- 4 585 996
- US-A- 4 663 585
- US-A1- 2003 067 311
- US-A1- 2007 227 880
- US-A1- 2012 290 229
- FAHMI DANIAR ET AL: "Impact of Diameter and Gap Distance on Partial Discharge Detection in Transformer Oil using RTL-SDR Method", 2018 INTERNATIONAL SEMINAR ON INTELLIGENT TECHNOLOGY AND ITS APPLICATIONS (ISITIA), IEEE, 30 August 2018 (2018-08-30), pages 135-140, XP033547694, DOI: 10.1109/ISITIA.2018.8711297 ISBN: 978-1-5386-7652-3 [retrieved on 2019-05-09]
- MOLLER R ET AL: "Development of a test bench to investigate the breakdown voltage of insulation oil in a frequency range between 1 kHz and 10 kHz", 2017 IEEE SECOND INTERNATIONAL CONFERENCE ON DC MICROGRIDS (ICDCM), IEEE, 27 June 2017 (2017-06-27), pages 160-165, XP033136406, DOI: 10.1109/ICDCM.2017.8001038 [retrieved on 2017-08-03]
- LI Y ET AL: "The square wave voltage method for the measurement of low level tan /spl delta/ of liquid dielectrics", PROPERTIES AND APPLICATIONS OF DIELECTRIC MATERIALS, 1997., PROCEEDING S OF THE 5TH INTERNATIONAL CONFERENCE ON SEOUL, SOUTH KOREA 25-30 MAY 1997, NEW YORK, NY, USA,IEEE, US, vol. 2, 25 May 1997 (1997-05-25), pages 1125-1128, XP010242359, DOI: 10.1109/ICPADM.1997.616646 ISBN: 978-0-7803-2651-4

## Description

### Technical Field

The present disclosure relates to non-destructive testing of a dielectric strength of a liquid. In particular, the present disclosure relates to non-destructive testing of a dielectric strength of a transformer oil.

### Background Art

As liquids age, their dielectric strength may decrease. When the dielectric strength of a liquid becomes too low, it may have to be replaced. Accordingly, there may be a need to regularly test the dielectric strength of a liquid. To this end, US 7,842,171 B2 teaches a testing arrangement for testing the dielectric strength of liquid. The testing arrangement has a test cell comprising an interior space for receiving the liquid. The arrangement further comprises test electrodes for generating an electric field in a test volume of the test cell. During the measurement process, the voltage is increased from an initial value until breakdown occurs.

US 4,663,585 A discloses an apparatus for testing the dielectric strength of insulating and/or cooling media, particularly insulating oils for electrical equipment. The material to be tested is contained in a vessel featuring electrodes providing a spark gap connected to the high voltage side of a testing generator. The internal resistance of the testing generator is made voltage-dependent and increases with increasing voltage.

US 4,585,996 A discloses an instrument for measuring electrical conductivity of a liquid which comprises a two-electrode probe for insertion into the liquid. A triangular waveform generator applies a voltage of fixed amplitude onto one electrode of the probe. The voltage drives an electric current through the liquid to the other electrode of the probe.

CN 106 443 386 A discloses a streamer discharge test system for insulating oil. The streamer discharge test system comprises an impulse voltage generator, a voltage divider, a transient current detection device, a discharge test oil tank, a high-speed imaging recorder, a synchronous triggering and measuring part and a photomultiplier. A high-voltage electrode and a grounding electrode are arranged in the discharge test oil tan and discharge streamers are formed between the high-voltage electrode and the grounding electrode under impulse voltage.

D. Fahmi, I. M. Yulistya Negara, D. A. Asfani, I. G. Ngurah Satriyadi Hernanda, M. Wahyudi and H. L. Al Azmi, "Impact of Diameter and Gap Distance on Partial Discharge Detection in Transformer Oil using RTL-SDR Method," 2018 International Seminar on Intelligent Technology and Its Applications (ISITIA), 2018, pp. 135-140, doi: 10.1109/ISITIA.2018.8711297, relates to a partial discharge detecting method.

Further relevant art may be found in RU 172345 U1 and FR 2 251 009 A1.

### Summary

The present disclosure provides methods and apparatus for non-destructive testing of a dielectric strength of a liquid.

The present invention is directed to a method for testing of a dielectric strength of a liquid according to claim 1 and to an apparatus for measuring the conductivity of a liquid according to claim 8. Embodiments of the invention are described in the dependent claims.

According to a first aspect, there is provided a method for non-destructive testing of a dielectric strength of a liquid. The method comprises increasing a field strength of an electric field until a charge transport through the liquid commences and limiting the charge transport through the liquid caused by the electric field, by decreasing the field strength as the charge transport through the liquid commences.

In this regard, the term "non-destructive testing", as used throughout the description and the claims, refers to a testing procedure which is designed such (and assumes) that the tested liquid can (still) be used in an employment scenario for which it has been tested. In other words, the term "non-destructive testing", as used throughout the description and the claims, means that the liquid is not altered in a way that makes it substantially inferior or unusable in view of its intended purpose. For instance, if the tested liquid (e.g. an oil) is used for insulation, "non-destructive testing" would be testing that does not, or at least not substantially reduce the dielectric strength of said liquid. Hence, the term "non-destructive testing", as used throughout the description and the claims, may refer to a testing procedure that does not, or at least not substantially, degrade a liquid in terms of its capability to insulate. For example, "non-destructive testing" would avoid the formation of gases or particles in the liquid and would not change the composition of the tested liquid or leave the composition of the tested liquid substantially unaltered.

Moreover, the term "dielectric strength", as used throughout the description and the claims, is to be construed broadly and shall cover any property that enables a judgement on the liquid's capability to avoid a charge transport between structures of different electrical potential through the liquid. In other words, testing a dielectric strength of a liquid does not necessarily require measuring the maximum electric field or voltage the liquid can withstand. For example, it may be enough to determine whether the liquid can withstand a particular electric field or voltage. Hence, the formulation "testing the dielectric strength", as used throughout the description and the claims, covers cases where (a value indicating) the maximum electric field or voltage which the liquid can withstand is determined, but also cases where it is determined whether the liquid can withstand a particular electric field or voltage. Moreover, it shall also cover cases where the maximum electric field or voltage is not exactly but only approximately determined.

Furthermore, the formulation "increasing a field strength of an electric field", as used throughout the description and the claims, is not limited to homogenous fields. I. e., the electric field may be inhomogeneous and have a first field strength at spot A and a second field strength at spot B, where the first and second field strengths differ from each other. In this case, the formulation "increasing a field strength of an electric field", as used throughout the description and the claims, is to be interpreted as increasing the first field strength at spot A and the second field strength at spot B. For example, if the electric field is generated by two electrodes, increasing the field strength of the electric field may, for instance, be just another term for increasing the voltage between the electrodes.

In addition, the formulation "until a charge transport through the liquid commences", as used throughout the description and the claims, is to be construed broadly and shall cover scenarios where a charge transport actually commences earlier but cannot be detected with sufficient certainty, or where the field strength is increased in (small) steps and a lowest field strength at which a charge transport through the liquid would occur is missed. In other words, the formulation "until a charge transport through the liquid commences", as used throughout the description and the claims, means that a search for the field strength at which the charge transport commences is carried out. It does, however, not necessarily mean that the result of said search is exactly said field strength.

Moreover, the formulation "limiting the charge transport through the liquid", as used throughout the description and the claims, particularly refers to determining a maximum acceptable charge transport and taking measures to avoid that a (substantially) higher charge transport as the one that has just commenced occurs. In other words, the formulation "limiting the charge transport through the liquid", as used throughout the description and the claims, is not to be understood as being directed at limiting the breakthrough current. Rather, an electric breakthrough (as such) is avoided by choking off the charge transport. However, choking off does not mean that no charge transport occurs. Rather, the commencing charge transport is limited at an early stage which avoids an electric breakthrough.

Similarly, the formulation "decreasing the field strength", as used throughout the description and the claims, is not to be construed as relating to a sudden decrease in field strength that occurs as a result of an electric breakthrough. Rather, the formulation "decreasing the field strength", as used throughout the description and the claims, shall be understood as relating to means for limiting the charge transport at an early stage to avoid an electric breakthrough. In other words, the field strength is decreased before an electric breakthrough occurs.

Avoiding an electric breakthrough reduces or mitigates the risk of damaging the liquid, enabling or facilitating both, inline testing and continued use of the tested liquid.

The field strength may be decreased before sparking occurs. In other words, the method may prevent sparking while testing the liquid.

Accordingly, a damage of the liquid may be prevented.

The field strength may be increased in steps and decreased to zero between consecutive steps.

I.e., short voltage pulses may be applied to the electrodes to reduce the time during which the fluid is exposed to a voltage.

The electric field may be generated by connecting electrodes to a charged capacitor or a cascade of charged capacitors and the field strength may be decreased as the capacitor/cascade is discharged due to the charge transport through the liquid.

Hence, if an amount of electric energy stored by the capacitor(s) is sufficiently small, an electric breakthrough can be prevented. Moreover, a current limiter may be used to limit the current flowing through the liquid.

The method may further comprise disconnecting the electrodes from the capacitor/cascade, charging the capacitor/cascade, and reconnecting the electrodes to the charged capacitor/cascade, wherein repeating the steps of disconnecting, charging, and connecting serves to increase the field strength of the electric field until the charge transport through the liquid commences.

Hence, a risk of inadvertently causing an electric breakthrough by a faulty component that overcharges the capacitor/cascade can be avoided, as the electrodes are disconnected from the capacitor/cascade while charging.

By repeating the steps of disconnecting, charging, and connecting (in consecutive cycles), voltage pulses may be applied to the electrodes.

By generating the electric field only for a short duration, a strain imposed on the liquid may be kept low.

The method may further comprise determining an electric field strength at which the fluid might be damaged and limiting the charging of the capacitor based on the determined electric field strength.

For example, fluid samples may be exposed to different electric fields to determine a field strength of an electric field which damages the liquid (e.g., irreversibly reduces the dielectric strength or irreversibly changes other physical or chemical properties). A damage of the liquid may be assumed if a plasma is produced. The determined electric filed (at which a plasma is produced) minus a safety margin may be used as an upper limit for the electric field strength.

The method may further comprise comparing the field strength at which the charge transport through the liquid commences, or a value which depends on the field strength and/or the charge transport, to a reference and outputting an alert if a deviation of the field strength or the value from the reference is outside a tolerance region.

By comparing the field strength or the value to the reference, it is, for example, possible to discover aging effects and to take appropriate action before the liquid fails.

According to a second aspect, there is provided a method for inline testing of a dielectric strength of a liquid. The method comprises setting a field strength of an electric field to a predetermined value, detecting, that a charge transport through the liquid commences after a period has passed, during which no charge transport through the liquid has occurred, and limiting the charge transport through the liquid by decreasing the field strength as the charge transport through the liquid commences.

I.e., instead of actively searching for the field strength at which a charge transport through the liquid commences, the test may be designed to discover aging effects as they occur. In other words, a commencing charge transport may be used as an indicator that the dielectric strength has decreased over time and that appropriate action is to be taken. For example, the liquid may be replaced, or an additive may be added to the liquid to undo or delay degradation.

The liquid may be an insulating oil. For example, the liquid may be a transformer oil and the dielectric strength of the transformer oil may be tested while a transformer, which is insulated by the transformer oil, is in operation.

According to a third aspect, there is provided an apparatus for measuring a conductivity of a liquid. The apparatus comprises a first electrode, a second electrode and a current sensor configured to monitor a charge transport between the electrodes. The apparatus is configured to increase a voltage applied to the electrodes until the current sensor detects a charge transport between the electrodes and to reduce the voltage applied to the electrodes as the charge transport between the electrodes commences.

The apparatus may be configured to decrease the field strength before sparking occurs.

The apparatus may be configured to increase the field strength in steps and decrease the field strength to zero between consecutive steps.

The apparatus may further comprise a capacitor which is connected to the electrodes, wherein the voltage is decreased as the capacitor is discharged due to the charge transport between the electrodes.

The apparatus may be configured to increase the voltage applied to the electrodes by disconnecting the electrodes from the capacitor, charging the capacitor, and reconnecting the electrodes to the charged capacitor.

The apparatus may be further configured to repeat the disconnecting, charging, and connecting until the current sensor detects a charge transport between the electrodes.

In addition, the apparatus may be configured to limit the charging of the capacitor based on data kept in a storage of the apparatus, wherein the data indicates an allowed voltage region at which a damage of the fluid is avoided.

A damage of the fluid may be assumed if corona discharge occurs.

The apparatus may be further configured to compare the voltage at which the current sensor detects a charge transport between the electrodes, or a value depending on the voltage and/or the charge transport, to a reference. If a deviation of the voltage or the value from the reference is outside a tolerance region, the apparatus may raise an alert.

The electrodes may be installed in a Faraday cage which is configured to be immersed into an insulating oil of a transformer during operation of the transformer.

According to a fourth aspect, there is provided an apparatus for non-destructive testing of a dielectric strength of a liquid. The apparatus comprises a first electrode, a second electrode, a capacitor connected to the electrodes, and a current sensor configured to monitor a charge transport between the electrodes. The apparatus is configured to determine whether the current sensor detects a charge transport between the electrodes, when the capacitor applies a given voltage to the electrodes.

The apparatus may be configured to limit the charging of the capacitor based on data kept in a storage of the apparatus, wherein the data indicates an allowed energy level. An allowed energy level may be an energy level at which an occurrence of a corona discharge is avoided.

It will be appreciated that the features and attendant advantages of the disclosed methods may be realized by the disclosed apparatus and vice versa. Moreover, it is noted that throughout the description, features in brackets are to be regarded as optional.

### Brief Description of Drawings

The foregoing aspects and many of the attendant advantages will become more readily appreciated as the same becomes better understood by reference to the following description of embodiments, when taken in conjunction with the accompanying drawings, wherein like reference numerals refer to like parts throughout the various views, unless otherwise specified.
Fig. 1 illustrates a process for testing a dielectric strength of a liquid by measuring a conductivity of the liquid in an electric field, wherein the field strength is slowly increased until a charge transport through the liquid commences;
Fig. 2 illustrates a process for testing a dielectric strength of a liquid by measuring a conductivity of the liquid in a pulsating electric field, wherein the field strength is increased in small steps until a charge transport through the liquid commences;
Fig. 3 illustrates an employment of the processes illustrated in Fig. 1 and Fig. 2 for inline testing;
Fig. 4 illustrates a modification of the processes illustrated in Fig. 1 and Fig. 2 that may also be used for inline testing;
Fig. 5, Fig. 6, Fig. 7, Fig. 8, Fig. 9 and Fig. 10 schematically illustrate electrodes that may be used for generating the electric field;
Fig. 11 and Fig. 12 schematically illustrate exemplary details relating to the process illustrated in Fig. 2;
Fig. 13 shows a block diagram of a method that is based on the processes illustrated in Fig. 1 and Fig. 2; and
Fig. 14 shows a block diagram of a method that is based on the process illustrated in Fig. 4.

Notably, the drawings are not drawn to scale and unless otherwise indicated, they are merely intended to conceptually illustrate the structures and procedures described herein.

### Description of Embodiments

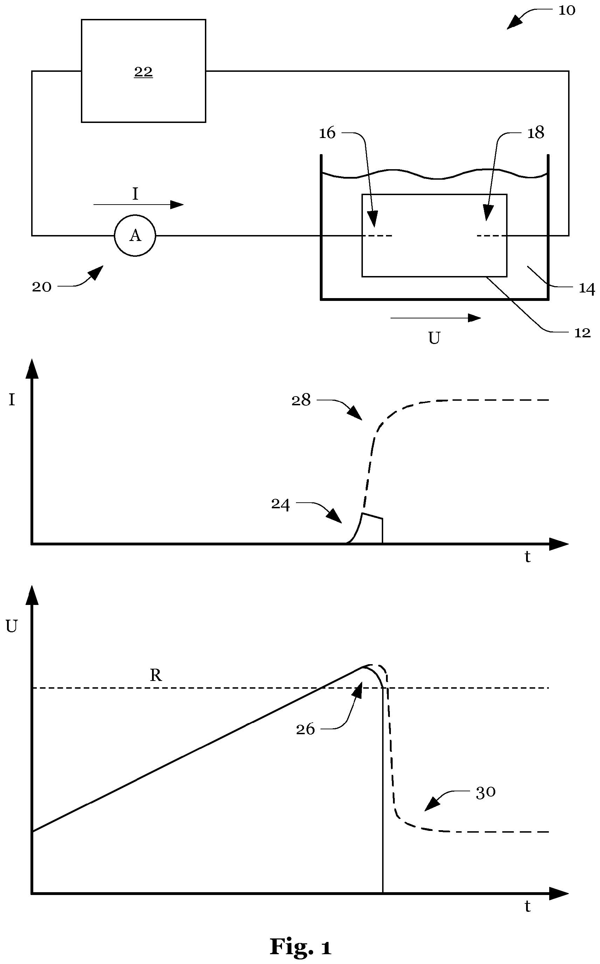

Fig. 1 shows an apparatus 10. The apparatus 10 comprises a Faraday cage 12 immersed in a liquid 14. The Faraday cage 12 encloses a first electrode 16 and a second electrode 18 (indicated by broken line) and has openings which allow the liquid 14 to flow into/through the cage 12. Moreover, the apparatus 10 may comprise a pump for constantly circling the liquid 14 into and out of the cage 12. The apparatus 10 further comprises a current sensor 20 and a controller 22. The controller 22 is configured to increase a voltage U applied to the electrodes 16, 18 until the current sensor 20 detects a charge transport (I>o) between the electrodes 16, 18. As the charge transport between the electrodes commences 24, the voltage U applied to the electrodes 16, 18 is reduced 26 to avoid corona discharge or an electrical breakthrough (the latter being schematically indicated by broken lines 28, 30).

The voltage U at which the charge transport commences 24 may be compared to a reference R. If the charge transport commences 24 at a voltage U that is higher than the reference R, the liquid 14 may pass the test. Otherwise, an alarm may be raised. Accordingly, the test may be aborted when the voltage U is increased above the reference R without causing a detectable current I. However, for the test to be effective (and yet non-destructive), a test run that results in an alarm should be based on increasing the voltage U until a charge transport through the liquid 14 commences 24 to avoid a corona discharge or an electric breakthrough. Moreover, determining a distance between the voltage U, at which a charge transport through the liquid 14 commences 24, and the reference R may also be helpful for determining the service life or a testing frequency with regard to the liquid 14 under test.

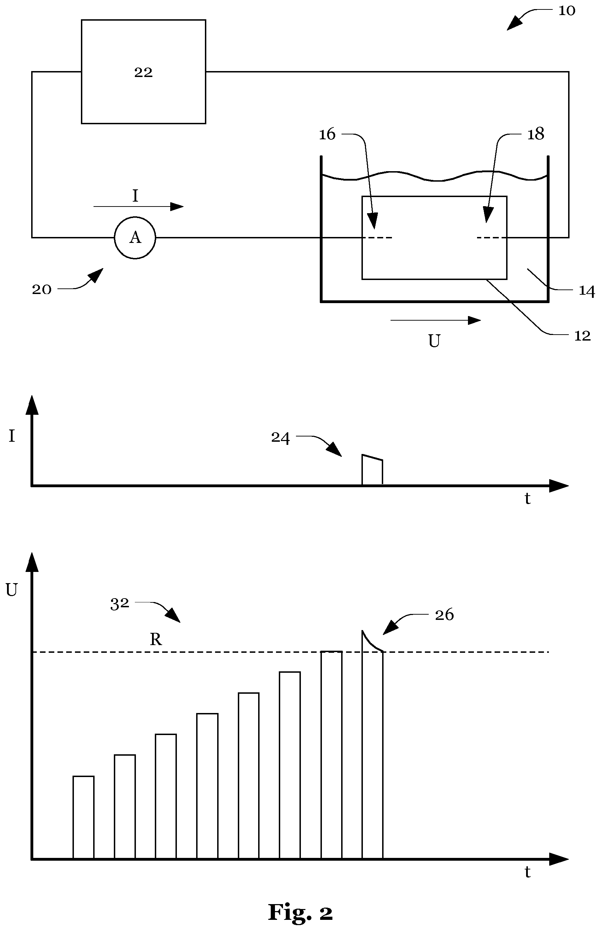

Fig. 2 illustrates a modification of the apparatus 10 of Fig. 1 which applies a series of voltage pulses 32 to the electrodes 16, 18. Each voltage pulse 32 is slightly stronger than its predecessor. If the current sensor 20 detects a charge transport (I>o) 24 between the electrodes 16, 18, the process is stopped. I.e., no further (stronger) voltage pulse 32 is applied to the electrodes 16, 18 to avoid a corona discharge or an electrical breakthrough.

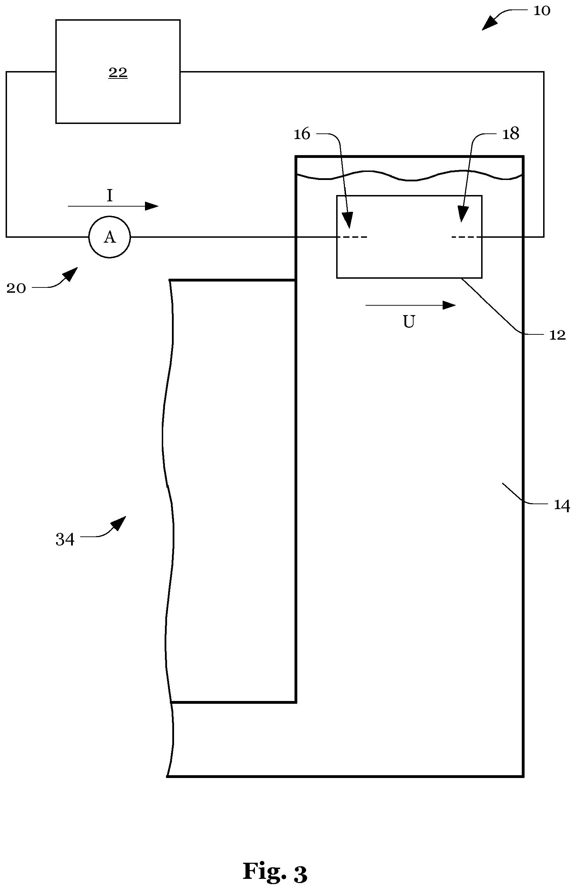

As indicated in Fig. 3, the testing may be performed inline by immersing the cage 12 into a liquid 14 that insulates and/or cools an electrical device 36. For example, the electrical device 34 may be a transformer and the liquid 14 may be a transformer oil which is used for insulating and cooling the transformer. Since corona discharge can be avoided, the transformer oil is not degraded, and the testing may be performed (continuously or in certain intervals) while the transformer is in operation. This may also improve testing accuracy as the transformer oil does not have to be filled into a testing vessel which bears the risk that unwanted substances are inadvertently added to the liquid 14.

The testing may also be performed by pouring (a few drops of) the liquid 14 into a measurement chamber of the apparatus 10. Or, the apparatus 10 may be attached to the transformer and the transformer oil may be fed by a pump into the measurement chamber.

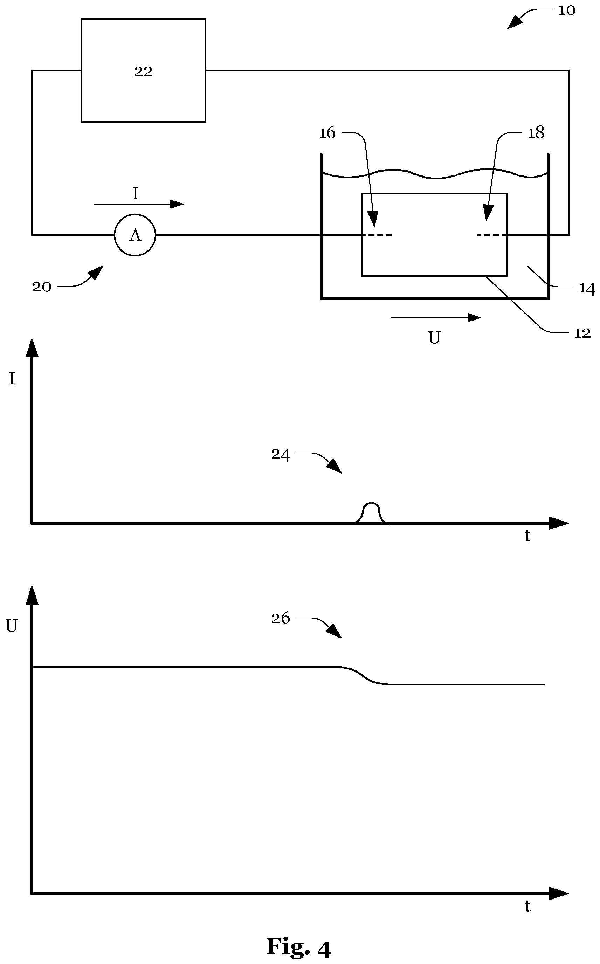

Fig. 4 illustrates a modification of the processes illustrated in Fig. 1 and Fig. 2 that may also be used for inline testing (as illustrated, for example, in Fig. 3). Instead of searching for the voltage U at which a charge transport through the liquid 14 commences, the voltage U is kept constant (at a predetermined value) until the decreasing dielectric strength of the liquid 14 gives way to a charge transport 24. In other words, if a charge transport 24 through the liquid 14 commences after a period during which no charge transport through the liquid has occurred, it can be concluded that the dielectric strength of the liquid 14 has decreased. Once the charge transport 24 through the liquid 14 commences, the voltage U may be decreased to limit the charge transport through the liquid 14, thereby avoiding a corona discharge or an electric breakthrough. Moreover, a current limiter may be used to limit the current flowing through the liquid 14.

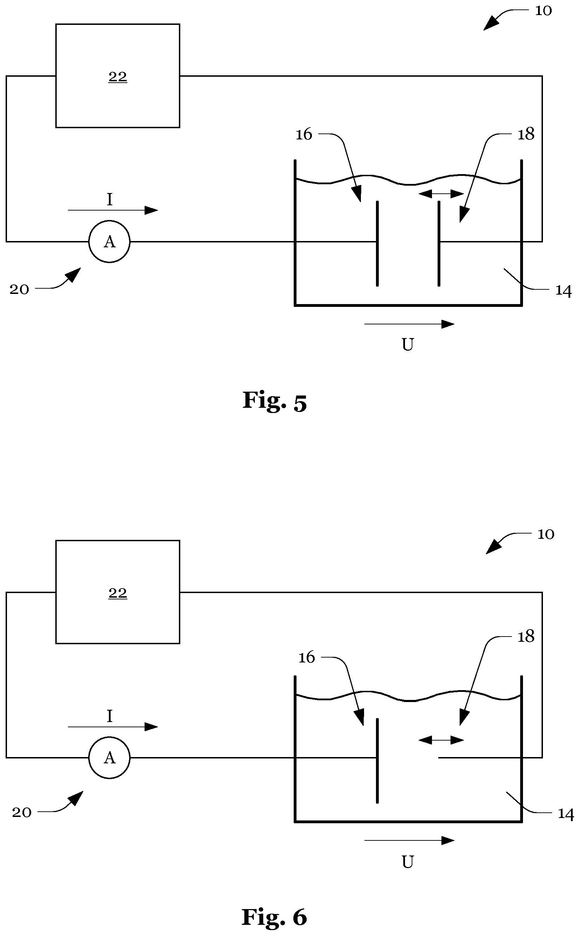

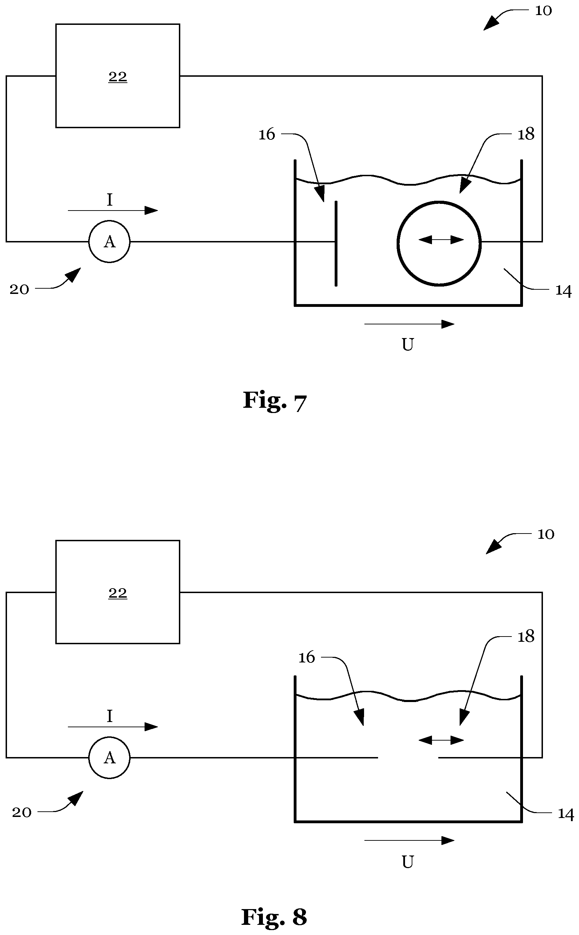

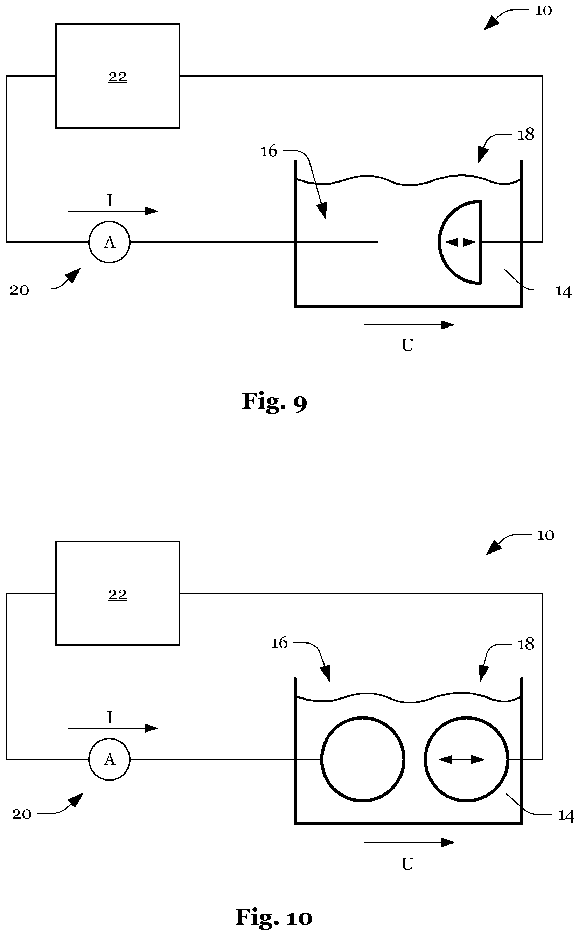

As shown in Fig. 5, the electrodes 16, 18 may be formed as parallel plates/discs. The distance between the plates/discs may be adjustable as indicated by the arrow. For example, one or both plates/discs may be movable by rotating a screw. However, the invention is not limited to a particular electrode-type. For example, as shown in Fig. 6, one electrode 16 may be formed as a plate/disc and the other electrode 18 may have a tip. Moreover, as shown in Fig. 7, one electrode 16 may be formed as a plate/disc and the other electrode 18 may be formed as a sphere. Or, as shown in Fig. 8, both electrodes 16, 18 may have a tip. Furthermore, as shown in Fig. 9, one electrode 16 may have a tip and the other electrode 18 may be formed as a semisphere. In addition, as shown in Fig. 10, both electrodes 16, 18 may be formed as spheres.

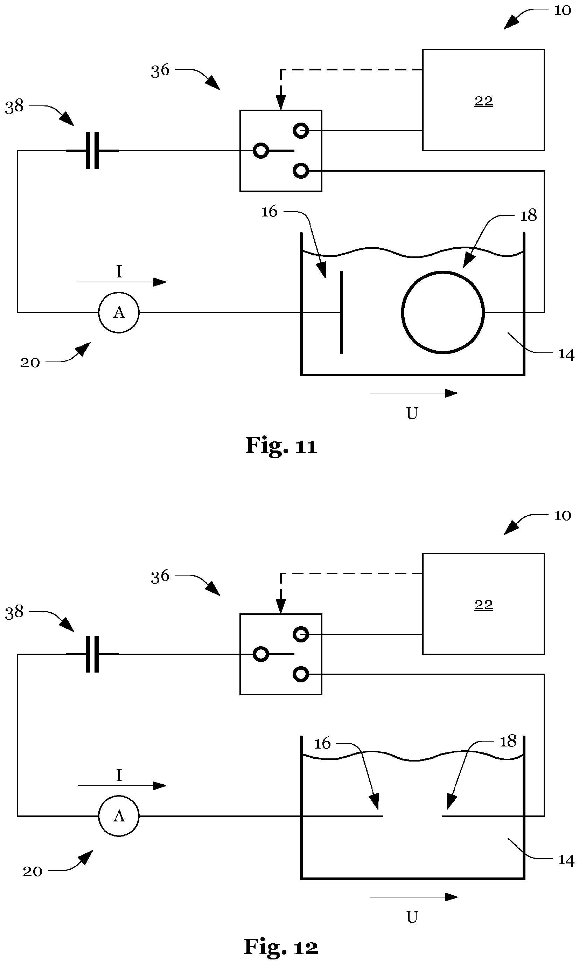

Fig. 11 schematically illustrates further exemplary details for carrying-out the process illustrated in Fig. 2. Here, the apparatus 10 is provided with a switching arrangement 36 for connecting/disconnecting the electrodes 14, 16 and a capacitor 38. When connected, the capacitor 38 may be discharged by a current through the liquid 14. When disconnected, the capacitor 38 may not be discharged by a current through the liquid 14. As the capacitor 38 is discharged when a charge transport thought the liquid 14 commences, the voltage U applied to the electrodes 16, 18 decreases, thereby suppressing a further charge transport. Thus, a corona discharge and an electric breakthrough can be avoided as the amount of electric energy stored by the capacitor 38 is limited. For example, data indicating an allowed voltage region or energy level at which a damage of the fluid 14 (due to a corona discharge or an electric breakthrough) is avoided, may be (persistently) stored in a storage (not shown) of the apparatus 10, or input during test set-up and said data may be taken into account when charging the capacitor 38. Moreover, an application-specific integrated circuit, ASIC, or a cascade of capacitors 38 may be used instead of the capacitor 38.

Moreover, the apparatus 10 may be provided with a current limiter (not shown) arranged in an electric path between the capacitor 38 and one of the electrodes 16, 18. Again, as shown in Fig. 12, the configuration is not limited to a particular electrode-type. Rather, any of the aforementioned electrode-type combinations may be used.

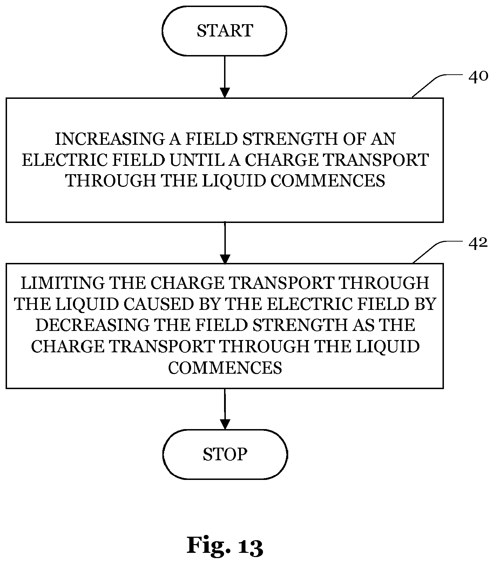

Fig. 13 shows a block diagram of a method that is based on the processes illustrated in Fig. 1 and Fig. 2. The method starts at step 40 with increasing the field strength of the electric field until a charge transport through the liquid 14 commences. As the charge transport through the liquid 14 commences, the charge transport through the liquid 14 caused by the electric field is limited by decreasing the field strength in step 42.

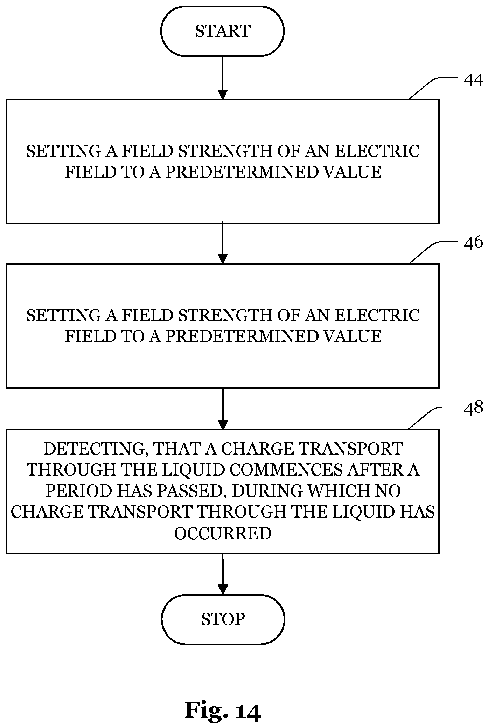

Fig. 14 shows a block diagram of a method that is based on the modified process illustrated in Fig. 4. The process starts at step 44 with setting the field strength of the electric field to a predetermined value. When it is detected at step 46 that a charge transport through the liquid commences after a period has passed, during which no charge transport through the liquid has occurred, the charge transport through the liquid 14 is limited in step 48 by decreasing the field strength as the charge transport through the liquid commences.

Thus, a corona discharge and an electric breakthrough can be avoided, which enables non-destructive testing of the dielectric strength of the liquid 14.

### Reference signs list

- 10: apparatus
- 12: Farraday cage
- 14: liquid
- 16: electrode
- 18: electrode
- 20: current sensor
- 22: controller
- 24: commencement of charge transport
- 26: voltage reduction
- 28: breakthrough current (assumed)
- 30: breakthrough voltage (assumed)
- 32: voltage pulses
- 34: electrical device (transformer)
- 36: switching arrangement
- 38: capacitor
- 40: step
- 42: step
- 44: step
- 46: step
- 48: step
- I: current
- R: reference
- U: voltage

## Claims

1. A method for testing of a dielectric strength of a liquid (14), the method comprising:
increasing (40) a field strength of an electric field
**characterized in that**
the testing is non-destructive testing;
and **in that** the method further comprises the following steps:
detecting that a charge transport through the liquid commences;
increasing the field strength of the electric field until a charge transport through the liquid (14) commences; and
limiting (42) the charge transport through the liquid (14) caused by the electric field by decreasing the field strength as the charge transport through the liquid (14) commences.

2. The method of claim 1, wherein the field strength is decreased before sparking occurs.

3. The method of claim 1 or 2, wherein the field strength is increased in steps and decreased to zero between consecutive steps.

4. The method of any one of claims 1 to 3, wherein:
the electric field is generated by connecting electrodes (16, 18) to a charged capacitor (38) or a cascade of capacitors (38); and
the field strength is decreased as the capacitor/cascade (38) is discharged due to the charge transport through the liquid (14).

5. The method of claim 4, further comprising:
disconnecting the electrodes (16, 18) from the capacitor/cascade (38);
charging the capacitor/cascade (38); and
reconnecting the electrodes (16, 18) to the charged capacitor/cascade (38);
wherein repeating the steps of disconnecting, charging, and connecting serves to increase the field strength of the electric field until the charge transport through the liquid (14) commences.

6. The method of any one of claims 1 to 5, the method further comprising:
comparing the field strength at which the charge transport through the liquid (14) commences, or a value which depends on the field strength and/or the charge transport, to a reference (R); and
outputting an alert if a deviation of the field strength or the value from the reference (R) is outside a tolerance region.

7. The method of any one of claims 1 to 6, wherein the liquid (14) is a transformer oil and the dielectric strength of the transformer oil is tested while the transformer oil insulates a transformer which is in operation.

8. An apparatus (10) for measuring a conductivity of a liquid (14), the apparatus comprising:
a first electrode (16);
a second electrode (18); and
a current sensor (20) configured to monitor a charge transport between the electrodes (16, 18);
**characterized in that**
the apparatus (10) is configured to:
increase a voltage (U) applied to the electrodes (16, 18) until the current sensor (20) detects a charge transport between the electrodes (16, 18); and
reduce the voltage (U) applied to the electrodes (16, 18) as the charge transport between the electrodes (16, 18) commences.

9. The apparatus of claim 8, wherein the apparatus (10) is configured to decrease the field strength before sparking occurs.

10. The apparatus of claim 8 or 9, wherein the apparatus (10) is configured to increase the field strength in steps and decrease the field strength to zero between consecutive steps.

11. The apparatus (10) of any one of claims 8 to 10, further comprising:
a capacitor (38) connected to the electrodes (16, 18), wherein the voltage (U) is decreased as the capacitor (38) is discharged due to the charge transport between the electrodes (16, 18).

12. The apparatus (10) of claim 11, wherein the apparatus (10) is configured to increase the voltage (U) applied to the electrodes (16, 18) by:
disconnecting the electrodes (16, 18) from the capacitor (38);
charging the capacitor (38); and
reconnecting the electrodes (16, 18) to the charged capacitor (38).

13. The apparatus (10) of claim 12, wherein the apparatus (10) is configured to repeat the disconnecting, charging, and connecting until the current sensor (20) detects a charge transport between the electrodes (16, 18).

14. The apparatus (10) of any one of claims 8 to 13, wherein the apparatus (10) is further configured to compare the voltage (U) at which the current sensor (20) detects a charge transport between the electrodes (16, 18), or a value depending on the voltage and/or the charge transport, to a reference (R), and to raise an alert if a deviation of the voltage (U) or the value from the reference (R) is outside a tolerance region.

15. The apparatus (10) of any one of claims 8 to 14, wherein the electrodes (16, 18) are installed in a Faraday cage which is configured to be immersed into an insulating oil of a transformer during operation of the transformer.

## Patentansprüche

1. Verfahren zur Prüfung einer dielektrischen Festigkeit einer Flüssigkeit (14), wobei das Verfahren Folgendes umfasst:
Erhöhen (40) einer Feldstärke eines elektrischen Feldes, **dadurch gekennzeichnet, dass** die Prüfung eine zerstörungsfreie Prüfung ist;
und dadurch, dass das Verfahren weiter die folgenden Schritte umfasst:
Erkennen, dass ein Ladungstransport durch die Flüssigkeit einsetzt;
Erhöhen der Feldstärke des elektrischen Feldes, bis ein Ladungstransport durch die Flüssigkeit (14) einsetzt; und
Begrenzen (42) des durch das elektrische Feld verursachten Ladungstransports durch die Flüssigkeit (14) durch Verringern der Feldstärke, wenn der Ladungstransport durch die Flüssigkeit (14) einsetzt.

2. Verfahren nach Anspruch 1, wobei die Feldstärke vor dem Auftreten der Funkenbildung verringert wird.

3. Verfahren nach Anspruch 1 oder 2, wobei die Feldstärke schrittweise erhöht und zwischen aufeinanderfolgenden Schritten auf Null verringert wird.

4. Verfahren nach einem der Ansprüche 1 bis 3, wobei:
das elektrische Feld durch Verbinden von Elektroden (16, 18) mit einem geladenen Kondensator (38) oder einer Kaskade von Kondensatoren (38) erzeugt wird; und
die Feldstärke verringert wird, wenn der Kondensator/die Kaskade (38) aufgrund des Ladungstransports durch die Flüssigkeit (14) entladen wird.

5. Verfahren nach Anspruch 4, weiter umfassend:
Trennen der Elektroden (16, 18) von dem Kondensator/der Kaskade (38);
Laden des Kondensators/der Kaskade (38); und
Wiederverbinden der Elektroden (16, 18) an den geladenen Kondensator/die Kaskade (38);
wobei das Wiederholen der Schritte des Trennens, Ladens und Verbindens dazu dient, die Feldstärke des elektrischen Feldes zu erhöhen, bis der Ladungstransport durch die Flüssigkeit (14) einsetzt.

6. Verfahren nach einem der Ansprüche 1 bis 5, wobei das Verfahren weiter umfasst:
Vergleichen der Feldstärke, mit welcher der Ladungstransport durch die Flüssigkeit (14) einsetzt, oder eines Wertes, der von der Feldstärke und/oder dem Ladungstransport abhängt, mit einer Referenz (R); und
Ausgeben eines Alarms, wenn eine Abweichung der Feldstärke oder des Wertes von der Referenz (R) außerhalb eines Toleranzbereichs liegt.

7. Verfahren nach einem der Ansprüche 1 bis 6, wobei die Flüssigkeit (14) ein Transformatorenöl ist und die dielektrische Festigkeit des Transformatorenöls geprüft wird, während das Transformatorenöl einen Transformator isoliert, der in Betrieb ist.

8. Einrichtung (10) zum Messen einer Leitfähigkeit einer Flüssigkeit (14), wobei die Einrichtung Folgendes umfasst:
eine erste Elektrode (16);
eine zweite Elektrode (18); und
einen Stromsensor (20), der so konfiguriert ist, dass er einen Ladungstransport zwischen den Elektroden (16, 18) überwacht;
**dadurch gekennzeichnet, dass**
die Einrichtung (10) konfiguriert ist zum:
Erhöhen einer an die Elektroden (16, 18) angelegten Spannung (U), bis der Stromsensor (20) einen Ladungstransport zwischen den Elektroden (16, 18) erkennt; und
Reduzieren der an die Elektroden (16, 18) angelegten Spannung (U), wenn der Ladungstransport zwischen den Elektroden (16, 18) einsetzt.

9. Einrichtung nach Anspruch 8, wobei die Einrichtung (10) so konfiguriert ist, dass sie die Feldstärke vor dem Auftreten der Funkenbildung verringert.

10. Einrichtung nach Anspruch 8 oder 9, wobei die Einrichtung (10) so konfiguriert ist, dass sie die Feldstärke schrittweise erhöht und die Feldstärke zwischen aufeinanderfolgenden Schritten auf Null verringert.

11. Einrichtung (10) nach einem der Ansprüche 8 bis 10, weiter umfassend:
einen Kondensator (38), der mit den Elektroden (16, 18) verbunden ist, wobei die Spannung (U) verringert wird, wenn der Kondensator (38) aufgrund des Ladungstransports zwischen den Elektroden (16, 18) entladen wird.

12. Einrichtung (10) nach Anspruch 11, wobei die Einrichtung (10) so konfiguriert ist, dass sie die an den Elektroden (16, 18) angelegte Spannung (U) erhöht durch:
Trennen der Elektroden (16, 18) vom Kondensator (38);
Laden des Kondensators (38); und
Wiederverbinden der Elektroden (16, 18) an den geladenen Kondensator (38).

13. Einrichtung (10) nach Anspruch 12, wobei die Einrichtung (10) so konfiguriert ist, dass sie das Trennen, Laden und Verbinden wiederholt, bis der Stromsensor (20) einen Ladungstransport zwischen den Elektroden (16, 18) erkennt.

14. Einrichtung (10) nach einem der Ansprüche 8 bis 13, wobei die Einrichtung (10) weiter so konfiguriert ist, dass sie die Spannung (U), mit welcher der Stromsensor (20) einen Ladungstransport zwischen den Elektroden (16, 18) erkennt, oder einen von der Spannung und/oder dem Ladungstransport abhängigen Wert mit einer Referenz (R) vergleicht und einen Alarm auslöst, wenn eine Abweichung der Spannung (U) oder des Wertes von der Referenz (R) außerhalb eines Toleranzbereichs liegt.

15. Einrichtung (10) nach einem der Ansprüche 8 bis 14, wobei die Elektroden (16, 18) in einem Faradayschen Käfig installiert sind, der so konfiguriert ist, dass er während des Betriebs des Transformators in ein Isolieröl eines Transformators eingetaucht wird.

## Revendications

1. Procédé pour tester la résistance diélectrique d'un liquide (14), le procédé comprenant l'étape consistant à :
augmenter (40) une intensité de champ d'un champ électrique, **caractérisé en ce que** le test est un test non destructif ;
et **en ce que** le procédé comprend en outre les étapes consistant à :
détecter qu'un transport de charge à travers le liquide commence ;
augmenter l'intensité de champ du champ électrique jusqu'à ce qu'un transport de charge à travers le liquide (14) commence ; et
limiter (42) le transport de charge à travers le liquide (14) provoqué par le champ électrique en diminuant l'intensité de champ lorsque le transport de charge à travers le liquide (14) commence.

2. Procédé selon la revendication 1, dans lequel l'intensité de champ est diminuée avant que des étincelles ne se produisent.

3. Procédé selon la revendication 1 ou 2, dans lequel l'intensité de champ est augmentée par étapes et diminuée jusqu'à zéro entre des étapes consécutives.

4. Procédé selon l'une quelconque des revendications 1 à 3, dans lequel :
le champ électrique est généré en connectant des électrodes (16, 18) à un condensateur chargé (38) ou à une cascade de condensateurs (38) ; et
l'intensité de champ diminue à mesure que le condensateur/la cascade (38) est déchargé(e) en raison du transport de charge à travers le liquide (14).

5. Procédé selon la revendication 4, comprenant en outre les étapes consistant à :
déconnecter les électrodes (16,18) du condensateur/de la cascade (38) ;
charger le condensateur/la cascade (38) ; et
reconnecter les électrodes (16,18) au condensateur/à la cascade chargé(e) (38) ;
dans lequel la répétition des étapes de déconnexion, de charge et de connexion sert à augmenter l'intensité de champ du champ électrique jusqu'à ce que le transport de charge à travers le liquide (14) commence.

6. Procédé selon l'une quelconque des revendications 1 à 5, le procédé comprenant en outre les étapes consistant à :
comparer l'intensité de champ à laquelle commence le transport de charge à travers le liquide (14), ou une valeur qui dépend de l'intensité de champ et/ou du transport de charge, à une référence (R) ; et
délivrer en sortie une alerte si un écart de l'intensité de champ ou de la valeur par rapport à la référence (R) se situe en dehors d'une zone de tolérance.

7. Procédé selon l'une quelconque des revendications 1 à 6, dans lequel le liquide (14) est une huile de transformateur et la résistance diélectrique de l'huile de transformateur est testée tandis que l'huile de transformateur isole un transformateur qui est en fonctionnement.

8. Appareil (10) pour mesurer une conductivité d'un liquide (14), l'appareil comprenant :
une première électrode (16) ;
une seconde électrode (18) ; et
un détecteur de force (20) configuré pour surveiller un transport de charge entre les électrodes (16,18) ;
**caractérisé en ce que**
l'appareil (10) est configuré pour :
augmenter une tension (U) appliquée aux électrodes (16, 18) jusqu'à ce que le capteur de courant (20) détecte un transport de charge entre les électrodes (16, 18) ; et
réduire la tension (U) appliquée aux électrodes (16, 18) lorsque le transport de charge entre les électrodes (16, 18) commence.

9. Appareil selon la revendication 8, dans lequel l'appareil (10) est configuré pour diminuer l'intensité de champ avant que des étincelles ne se produisent.

10. Appareil selon la revendication 8 ou 9, dans lequel l'appareil (10) est configuré pour augmenter l'intensité de champ par étapes et diminuer l'intensité du champ jusqu'à zéro entre des étapes consécutives.

11. Appareil (10) selon l'une quelconque des revendications 8 à 10, comprenant en outre :
un condensateur (38) connecté aux électrodes (16, 18), dans lequel la tension (U) diminue à mesure que le condensateur (38) est déchargé en raison du transport de charge entre les électrodes (16,18).

12. Appareil (10) selon la revendication 11, dans lequel l'appareil (10) est configuré pour augmenter la tension (U) appliquée aux électrodes (16, 18) en :
déconnectant les électrodes (16, 18) du condensateur (38) ;
chargeant le condensateur (38) ; et
reconnectant les électrodes (16, 18) au condensateur chargé (38).

13. Appareil (10) selon la revendication 12, dans lequel l'appareil (10) est configuré pour répéter la déconnexion, la charge et la connexion jusqu'à ce que le capteur de courant (20) détecte un transport de charge entre les électrodes (16, 18).

14. Appareil (10) selon l'une quelconque des revendications 8 à 13, dans lequel l'appareil (10) est en outre configuré pour comparer la tension (U) à laquelle le capteur de courant (20) détecte un transport de charge entre les électrodes (16, 18), ou une valeur dépendant de la tension et/ou du transport de charge, à une référence (R), et pour déclencher une alerte si un écart de la tension (U) ou de la valeur par rapport à la référence (R) se situe en dehors d'une zone de tolérance.

15. Appareil (10) selon l'une quelconque des revendications 8 à 14, dans lequel les électrodes (16, 18) sont installées dans une cage de Faraday qui est configurée pour être immergée dans une huile isolante d'un transformateur pendant le fonctionnement du transformateur.
